# EUROPEAN PATENT SPECIFICATION

(11) **EP 3 314 740 B1**
(45) Date of publication and mention of the grant of the patent: **27.05.2020**
(21) Application number: 16736848.9
(22) Date of filing: 07.07.2016
(51) Int. Cl.: H02M 3/335, H01F 27/00, H02M 1/00

(54) **TWO-TRANSFORMER THREE-PHASE DC-DC RESONANT CONVERTER**
DREIPHASIGER GLEICHSTROMRESONANZWANDLER MIT ZWEI TRAFOS
CONVERTISSEUR RÉSONNANT CC-CC TRIPHASÉ À DEUX TRANSFORMATEURS

(43) Date of publication of application: 02.05.2018
(73) Proprietor: Huawei Technologies Co., Ltd., Longgang District Shenzhen, Guangdong 518129 (CN)
(72) Inventor: TORRICO-BASCOPÉ, Grover, 164 40 Kista (SE)
(74) Representative: Körber, Martin Hans
(86) International application number: PCT/EP2016/066080
(87) International publication number: WO 2018/006960

(56) References cited:
- EP-A1- 1 756 935
- EP-A1- 2 887 523
- JP-A- 2010 124 671
- US-A1- 2004 136 215
- SHI YONG ET AL: "Soft Switching PWM Cascaded Three-Level Combined DC-DC Converters With Reduced Filter Size and Wide ZVS Load Range", IEEE TRANSACTIONS ON POWER ELECTRONICS, INSTITUTE OF ELECTRICAL AND ELECTRONICS ENGINEERS, USA, vol. 30, no. 12, 1 December 2015 (2015-12-01), pages 6604-6616, XP011667319, ISSN: 0885-8993, DOI: 10.1109/TPEL.2015.2391285 [retrieved on 2015-08-24]

## Description

### TECHNICAL FIELD

The aspects of the present disclosure relate generally to power conversion apparatus and more particularly to resonant DC to DC power converters.

### BACKGROUND

Resonant DC to DC converters are considered to be attractive power conversion solutions for the many benefits they can provide. Following a resonant tank with transformers provides galvanic isolation which is important for level conversion as well as for safety. In certain applications, galvanic isolation is required for proper operation. Resonant converters also have inherent properties, such as soft switching of the semiconductor switches, which lead to high efficiency and low noise.

The developing trends of the isolated direct current-direct current (DC-DC) converters are very high efficient, high power density and low cost. The resonant DC-DC converters are suitable technology to achieve high efficiency in power converters due to the intrinsic capability to achieve soft switching (i.e. zero voltage switching (ZVS) and zero current switching (ZCS)). It is also possible to increase the switching frequencies in order to reduce the size of the reactive components of the system. A three-phase resonant converter of this type is e.g. disclosed on EP2887523A1.

However, there are still drawbacks regarding the conventional three-phase resonant converter operating at high frequency (HF). Galvanic isolation in three-phase converters poses challenges in the construction and the connection types of the three-phase resonant converter. The common transformer and transformer connections types for the three-phase resonant converter are three winding transformers as e.g. disclosed in EP2887523A1. The cost of this existing technology increases with attempts at higher efficiency and reduced volume and weight.

Accordingly, it would be desirable to provide a DC-DC converter topology that addresses at least some of the problems identified above.

### SUMMARY

It is an object of the present invention to provide improved resonant DC to DC converter topologies that can deliver better efficiency and lower noise from smaller packages. This object is solved by the subject matter of the independent claims. Further advantageous modifications can be found in the dependent claims.

According to a first aspect of the present invention the above and further objects and advantages are obtained by a resonant converter circuit comprising a resonant tank circuit and a transformer circuit, wherein the resonant tank circuit is connected to a primary side of three connection points of the transformer circuit configured to receive a three-phase power input from the resonant tank circuit, the transformer circuit comprising: a first transformer and a second transformer, a first terminal of the first transformer connected to a first terminal of the second transformer, wherein the transformer circuit is a two-winding high frequency transformer circuit. The aspects of the disclosed embodiments provide a topological circuit for a three-phase DC-DC converter with a reduced number of transformers or transformer windings. This allows for a simplified and more efficient layout of the converter due to the reduction in transformer windings. The aspects of the disclosed embodiments provide a three-phase resonant converter that includes a transformer circuit with only two transformer windings. The reduced number of windings lowers the volume of the resonant converter, as well as lowering weight and cost while providing higher efficiency and reliability.

Further, according to the first aspect, the primary side of the transformer circuit comprises a first input node formed by a connection of the second terminal of the first transformer and a first terminal of the inductor, a second input node formed by the connection of the first terminal of the first transformer and the first terminal of the second transformer and a third input node formed by a connection of the second terminal of the second transformer and a second terminal of the inductor. This aspect provides a two-winding transformer for a three-phase resonant converter.

Further, according to the first aspect, the resonant tank circuit comprises a first branch, a second branch and a third branch, wherein the first branch is connected to the first input node of the transformer circuit, the second branch is connected to the second input node of the transformer circuit, and the third branch is connected to the third input node of the transformer circuit. The aspects of the disclosed embodiments provide resonant converter that is configured for three-phase and includes a transformer circuit with only two transformer windings. The reduced number of windings lowers the volume of the converter, as well as weight and cost while providing higher efficiency and reliability.

Further, according to the first aspect the first input node is configured to receive a first phase of the three-phase power input, the second node is configured to receive a second phase of the three-phase power input and the third node is configured to receive a third phase of the three-phase power input. This implementation form provides a two-winding transformer for a three-phase resonant converter.

Further, the transformer circuit includes a secondary side configured to deliver a three-phase power output, the secondary side comprising a first output node formed by a third terminal of the first transformer, a second output node formed by a connection of a fourth terminal of the first transformer and a fourth terminal of the second transformer, and a third output node formed by a third terminal of the second transformer. The two-transformer topological circuit for a resonant converter provides a three-phase power output with greater efficiency than can be achieved with three-transformer circuits.

In a first possible implementation form according to the first aspect, the first branch is connected between a first input node of the resonant tank circuit and the first input node of the transformer circuit, the second branch is connected between a second input node of the resonant tank circuit and the input node of the transformer circuit, and the third branch is connected between a third input node of the resonant tank circuit and the third input node of the transformer circuit. The aspects of the disclosed embodiments provide a three-phase resonant converter with a transformer circuit that has only two transformer windings. The reduced number of windings lowers the volume of the converter, as well as weight and cost while providing higher efficiency and reliability.

In a second possible implementation form according to the first aspect as such or according to the first possible implementation form of the first aspect, the first branch comprises a first branch inductor connected in series with a first branch capacitor, a first end of the first branch is connected to the first node of the transformer circuit; the second branch comprises a second branch inductor connected in series with a second branch capacitor, a first end of the second branch is connected to the second node of the transformer circuit; and the third branch comprises a third branch inductor connected in series with a third branch capacitor, a first end of the third branch is connected to the third node of the transformer circuit. The resonant converter of the disclosed embodiments includes a two-winding transformer circuit that is configured to connect to each branch of a three-phase resonant tank circuit to provide a three-phase power output.

In a third possible implementation form of the resonant converter circuit according to the first aspect as such or according to first or second possible implementation forms of the first aspect, the secondary side is configured to be connected to a three-phase rectifier circuit to deliver the three-phase power output, the first output node being configured to be connected to a first branch of the rectifier circuit, the second output node being configured to be connected to a second branch of the rectifier circuit and the third output node being configured to be connected to a third branch of the rectifier circuit. The two-transformer topological circuit for a resonant converter provides a three-phase power output with greater efficiency than can be achieved with three-transformer circuits.

According to a second aspect of the present invention the above and further objects and advantages are obtained by a three-phase resonant DC-DC converter system that includes a primary side, a secondary side and a resonant converter circuit according to the first aspects and possible implementation forms connected between the primary side and the secondary side. The aspects of the disclosed embodiments provide a three-phase resonant converter with a transformer circuit that includes only two transformer windings. The reduced number of windings in the transformer circuit lowers the volume, weight and cost of the converter system, while providing higher efficiency and reliability.

In a first possible implementation form of the three-phase resonant DC-DC converter system according to the second aspect as such the primary side comprises a DC voltage input circuit configured to receive a DC input voltage, the resonant tank circuit being connected to the transformer circuit to provide the three-phase power input to the transformer circuit and a switching circuit connected between the DC voltage input circuit and the resonant tank circuit. The resonant converter system of the disclosed embodiments can be applied to any three-phase topological circuit.

In a second possible implementation of the three-phase resonant DC-DC converter system according to the second aspect as such, or according to the first possible implementation form of the second aspect, the secondary side comprises a three-phase rectification circuit connected between the transformer circuit and a DC voltage output circuit, the rectification circuit configured to receive the three-phase power output signal from the transformer circuit. The resonant converter system of the disclosed embodiments can be applied to any three-phase topological circuit to provide a three-phase power output.

In a third possible implementation form of the three-phase resonant DC-DC converter system according to the second aspect as such or according to any one of the preceding possible implementation forms of the second aspect the switching circuit is a multi-level three-phase switching converter. The resonant converter system of the disclosed embodiments can be implemented in any suitable three-phase topological circuit including high-voltage applications.

In a fourth possible implementation form of the three-phase resonant DC-DC converter system according to the second aspect as such or according to any one of the preceding possible implementation forms of the second aspect the switches in the switching circuit and switches in the rectification circuit comprise gallium-nitride (GaN) transistors. The use of GaN devices increases efficiency at a reduced cost.

These and other aspects, implementation forms, and advantages of the exemplary embodiments will become apparent from the embodiments described herein considered in conjunction with the accompanying drawings. It is to be understood, however, that the description and drawings are designed solely for purposes of illustration and not as a definition of the limits of the disclosed invention, for which reference should be made to the appended claims. Additional aspects and advantages of the invention will be set forth in the description that follows, and in part will be obvious from the description, or may be learned by practice of the invention. Moreover, the aspects and advantages of the invention may be realized.

### BRIEF DESCRIPTION OF THE DRAWINGS

In the following detailed portion of the present disclosure, the invention will be explained in more detail with reference to the example embodiments shown in the drawings, in which:
Figure 1 is a block diagram illustrating an exemplary three-phase DC-DC resonant converter system incorporating aspects of the disclosed embodiments.
Figure 2 illustrates a schematic diagram of an exemplary transformer circuit incorporating aspects of the disclosed embodiments.
Figure 3 illustrates a schematic diagram of an exemplary three-phase DC-DC resonant converter circuit incorporating aspects of the disclosed embodiments.
Figure 4 illustrates a schematic diagram of an exemplary three-phase DC-DC resonant converter system incorporating aspects of the disclosed embodiments.
Figure 5 illustrates a schematic diagram an exemplary three-phase DC-DC resonant converter system incorporating aspects of the disclosed embodiments.
Figure 6 illustrates a graph showing voltage gain characteristics for a resonant circuit incorporating aspects of the disclosed embodiments.
Figure 7 illustrates a exemplary multi-level three-phase DC-DC resonant converter system incorporating aspects of the disclosed embodiments.

### DETAILED DESCRIPTION OF THE DISCLOSED EMBODIMENTS

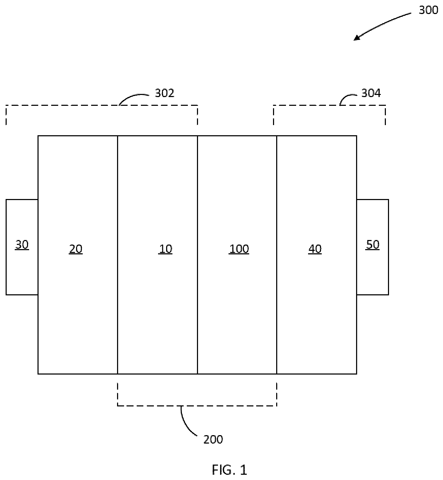

Referring to Figure 1 there can be seen an exemplary block diagram of a DC-DC three-phase resonant converter system 300 incorporating aspects of the disclosed embodiments. As shown in Figure 1, the three-phase resonant converter system 300 generally includes an input circuit or primary side 302, and an output circuit or secondary side 304. The primary side 302 generally comprises a DC voltage input circuit 30, an inverter circuit 20 and a resonant tank circuit 10. The secondary side 304 generally includes a rectification circuit 40 and a DC output voltage circuit 50. A transformer circuit 100 is connected between the primary side 302 and the secondary side 304. The aspects of the disclosed embodiments are directed to a topological circuit of a three-phase DC-DC resonant converter system 300 that includes a two winding high frequency transformer connection rather than the typical three winding transformer connection. Reducing the number of transformer windings, lowers the volume, weight and cost of the converter. The construction and layout of the converter system 300 is simplified, and the efficiency of the system 300 is improved.

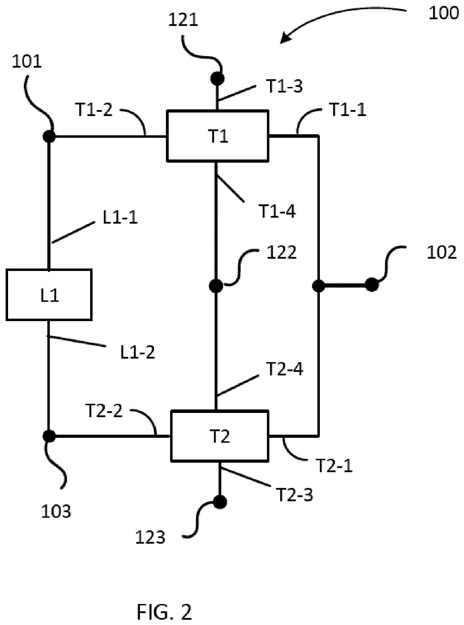

Figure 2 illustrates a schematic block diagram of an exemplary transformer circuit 100 incorporating aspects of the disclosed embodiments. The transformer circuit 100 is a two-winding high frequency transformer circuit that is suitable for a high efficiency, high power density and low cost DC-DC converter in any application that requires galvanic isolation and independence between the input voltage value and the output voltage value of the converter system.

The transformer circuit 100 of the disclosed embodiments includes two high frequency transformers T1 and T2. The transformers T1 and T2 can comprise two single transformers. Alternatively, the transformers T1 and T2 can be integrated in one single core, which can be referred to as a two winding transformer. In one embodiment, the transformers T1 and T2 are high frequency transformers with a turns ratio of n:1. For the purposes of the disclosure herein, the two transformers, or transformer windings, will be referred to as transformers T1 and T2.

As shown in Figure 2, a first terminal T1-1 of the first transformer T1 is connected to a first terminal T2-1 of the second transformer T2. An inductor L1 is connected between a second terminal T1-2 of the first transformer T1 and a second terminal T2-2 of the second transformer T2.

The primary side of the transformer circuit 100 shown in Figure 2 includes three connection points or nodes 101, 102 and 103. The first connection point 101, also referred to as the first input node 101, is formed by the connection of the second terminal T1-2 of the first transformer T1 and a first terminal L1-1 of the inductor L1. A second connection point or input node 102 is formed by the connection of the first terminal T1-1 of the first transformer T1 and the first terminal T2-1 of the second transformer T2. The third connection point or input node 103 is formed by the connection of the second terminal T2-2 of the second transformer T2 and the second terminal LI-2 of the inductor L1. The first, second and third input nodes 101, 102 and 103, are configured to receive the first, second and third phases, respectively, of a three-phase input power.

In one embodiment, the primary side of the transformer circuit 100 is configured to be connected to a resonant tank circuit, such as the resonant tank circuit 10 illustrated in Figure 1. In the examples of Figure 1, 3 and 4, and as will be described further below, the resonant tank circuit 10 is a three-phase resonant tank circuit.

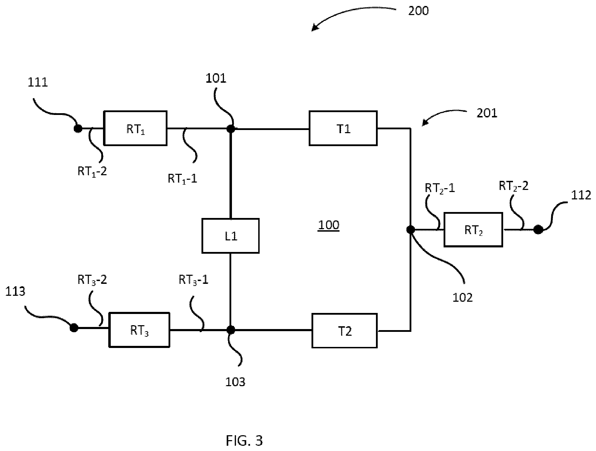

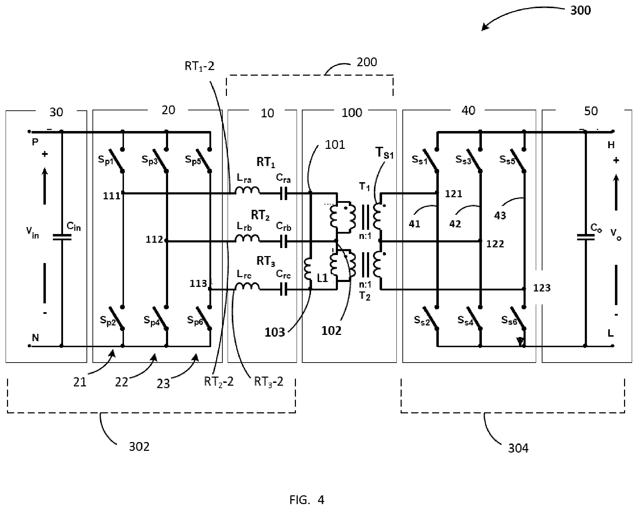

Referring to Figures 3 and 4, in one embodiment, the first input node 101 on the primary side of the transformer circuit 100 is configured to be connected to a first branch RT₁ of the resonant tank circuit 10. The second input node 102 on the primary side of the transformer circuit 100 is configured to be connected to a second branch RT₂ of the resonant tank circuit 10. The third input node 103 on the primary side of the transformer circuit 100 is configured to be connected to a third branch RT₃ of the resonant tank circuit 10. The first, second and third branches RT₁, RT₂ and RT₃ are connected to different phases of the three-phase power input.

The transformer circuit 100 shown in Figure 2 includes a secondary side comprising three connection points or output nodes 121, 122 and 123. The secondary side of the transformer circuit 100 is configured to deliver a three-phase power output.

In one embodiment, the first output node 121 is formed by a third terminal T1-3 of the first transformer T1. The second output node 122 is formed by a connection of a fourth terminal T1-4 of the first transformer T1 and a fourth terminal T2-4 of the second transformer T2. The third output node 123 is formed by the third terminal T2-3 of the second transformer T2.

The output nodes 121, 122 and 123 of the secondary side of the transformer circuit 100 is configured to be connected to a rectifier circuit, such as the three-phase rectifier circuit 40 shown in Figures 1 and 4. In this example, the first output node 121 is configured to be connected to first branch 41 of the rectifier circuit 40. The second output node 122 is configured to be connected to a second branch 42 of the rectifier and the third output node 123 is configured to be connected to a third branch 43 of the rectifier circuit 40.

The resonant converter system 300 shown in Figure 1 includes a resonant converter circuit 200. The resonant converter circuit 200 generally comprises a resonant tank circuit 10 and the transformer circuit 100. In one embodiment, as illustrated for example in Figures 3 and 4, the resonant tank circuit 10 is connected to the nodes 101, 102 and 103 on the primary side of the transformer circuit 100. The resonant tank circuit 10 can be configured to contain a single or multi-resonant tank in each phase.

The first branch RT₁ of the resonant tank circuit 40 is connected between a first input node 111 of the resonant tank circuit 10 and the first input node 101 of the transformer circuit 100. The second branch RT₂ of the resonant tank circuit 10 is connected between a second input node 112 of the resonant tank circuit 10 and the second input node 102 of the transformer circuit 100. The third branch RT₃ of the resonant tank circuit 10 is connected between the third input node 113 of the resonant tank circuit 10 and the third input node 103 of the transformer circuit 100.

As is illustrated in Figure 4, the resonant tank circuit 10 generally comprises an LLC type resonant tank and includes inductors Lᵣₐ, L_{rb} and L_{rc} in each branch RT₁, RT₂ and RT₃, respectively. The inductors Lᵣₐ, L_{rb}, L_{rc} in each branch or phase are followed by a respective capacitor Cᵣₐ, C_{rb} and C_{rc}. The inductors Lᵣₐ, L_{rb} and L_{rc} are the resonant inductors and can be constructed with independent cores or integrated in one single core. The capacitors Cᵣₐ, C_{rb} and C_{rc} are the resonant capacitors.

In one embodiment, the first branch RT₁ of the resonant tank circuit 10 comprises the inductor Lᵣₐ connected in series with the capacitor Cᵣₐ. A first end RT₁-1 of the first branch RT₁ is configured to be connected to the first node 101 of the transformer circuit 100. A first terminal of the capacitor Cᵣₐ forms the first end RT₁-1 in this example. A first terminal of the inductor Lᵣₐ forms the second end RT₁-2 of the first branch RT₁ and is connected to the first input node 111 of the inverter circuit 20.

The second branch RT2 of the resonant tank circuit 10 comprises the inductor L_{rb} connected in series with the capacitor C_{rb}. A first end RT₂-1 of the second branch RT₂ is configured to be connected to the second node 102 of the transformer circuit 100. A first terminal of the capacitor C_{rb} forms the first end RT₂-1 in this example. A first terminal of the inductor L_{rb} forms the second end RT₂-2 of the second branch RT₂ and is connected to the second input node 112 of the inverter circuit 20.

The third branch RT3 of the of the resonant tank circuit 10 comprises the inductor L_{rc} connected in series with the capacitor C_{rc}. A first end RT₃-1 of the third branch RT₃ is configured to be connected to the third node 103 of the transformer circuit 100. A first terminal of the capacitor C_{rc} forms the first end RT₃-1 in this example. A first terminal of the inductor L_{rc} forms the third end RT₃-2 of the third branch RT₃ and is connected to the third input node 113 of the inverter circuit 20.

Figure 4 is a schematic diagram of a three-phase resonant DC-DC converter system 300 incorporating aspects of the disclosed embodiments. The three-phase resonant DC-DC converter 300 is configured to receive a DC power Vin and create a three-phase AC power appropriate for driving the resonant converter circuit 200. The inverter or switching circuit 20 is configured to receive the DC input power Vᵢₙ from the DC voltage input circuit 30 across positive (+) and negative (-) input rails P, N. An input capacitor Cᵢₙ is coupled across the input rails P, N and provides filtering of the DC input power Vin.

In the example of Figure 4, the inverter circuit 20 includes three half bridge circuits 21, 22, 23 are coupled in parallel across the DC input power Vin and may be operated to produce a three-phase power at three output nodes 111, 112, 113. Each half bridge circuit 21, 22, 23 includes a pair of switches, Sₚ₁, Sₚ₂, Sₚ₃, Sₚ₄, Sₚ₅ and Sₚ₆, respectively. Each switch Sₚ₁, Sₚ₂, Sₚ₃, Sₚ₄, Sₚ₅, Sₚ₆ is configured to be operated, i.e. turned on or off, by a switch control signal (not shown). These pairs of switches allow the output nodes 111, 112, 113 to be alternately coupled to the positive input rail P or to the negative input rail N to create an AC power signal at the corresponding output node 111, 112, 113, as is generally understood.

The switches Sₚ₁, Sₚ₂, Sₚ₃, Sₚ₄, Sₚ₅, and Sₚ₆ can be any suitable type of transistors, such as for example, metal-oxide-semiconductor field-effect-transistors, (MOSFET), insulated gate bipolar transistor (IGBT), Gallium Nitride High Electron Mobility transistors (GaN-HEMT), and MOS-controlled thyristor (MCT). The semiconductor material of the devices can be based on silicon (Si), silicon-carbide (SiC), gallium nitride (GaN) as well as other semiconductor materials, or any combination thereof.

The resonant converter 200 is followed by the three-phase rectifying bridge cell or circuit 40 that is configured to receive a three-phase AC power and produce a DC output power Vₒ. The exemplary rectifier circuit 40 receives a three-phase AC power at the three rectifier circuit input nodes 121, 122, 123. The three-phase AC input power in this example is produced by the resonant circuit 200.

The DC output voltage circuit 50 includes a positive (+) output rail H and a negative (-) output rail L for the DC output power Vo. An output filter capacitor C_{O} is coupled across the positive (+) and negative (-) output rails H, L and is configured to filter noise and reduce ripple from the output power Vo.

Three half bridge circuits 41, 42, 43 are coupled in parallel across the output rails H, L. Each half bridge circuit 41, 42, 43 is configured to receive one phase of the three-phase AC power at a center or input node 121, 122, 123 of each half bridge circuit 41, 42, 43 respectively.

Each half bridge circuit 41, 42, 43 uses a pair of switches Sₛ₁, Sₛ₂; Sₛ₃, Sₛ₄; and Sₛ₅, Sₛ₆, respectively to rectify the three-phase AC power from the resonant converter 200. As with switches Sₚ₁, Sₚ₂, Sₚ₃, Sₚ₄, Sₚ₅, Sₚ₆ on the primary side of the converter system 300, the switches Sₛ₁, Sₛ₂, Sₛ₃, Sₛ₄, Sₛ₅, and Sₛ₆ may be any appropriate type of switching device configured to conduct, or not conduct, electric current based on switch control signals. If synchronous rectification (SR) is not implemented, the switches can comprise diodes.

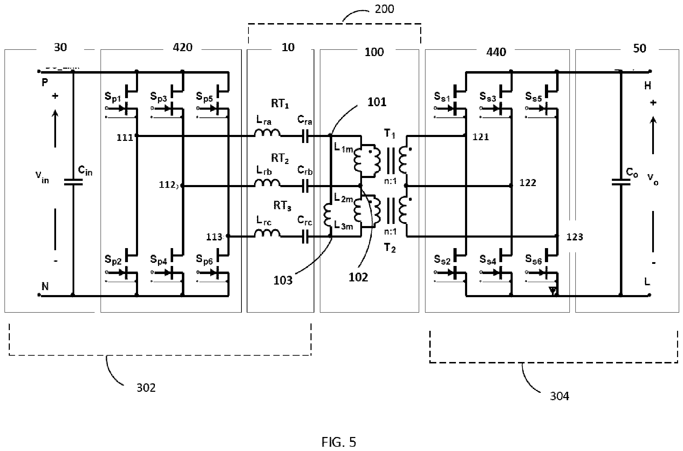

Figure 5 illustrates one embodiment of a resonant converter system 400 incorporating aspects of the disclosed embodiments. In this example, the switches Sₚ₁, Sₚ₂, Sₚ₃, Sₚ₄, Sₚ₅, Sₚ₆ of the inverter circuit 420 on the primary side of the converter system 400 and the switches Sₛ₁, Sₛ₂, Sₛ₃, Sₛ₄, Sₛ₅, Sₛ₆ of the rectifier circuit 440 on the secondary side of the converter system 400 are wide band GaN-HEMT transistors.

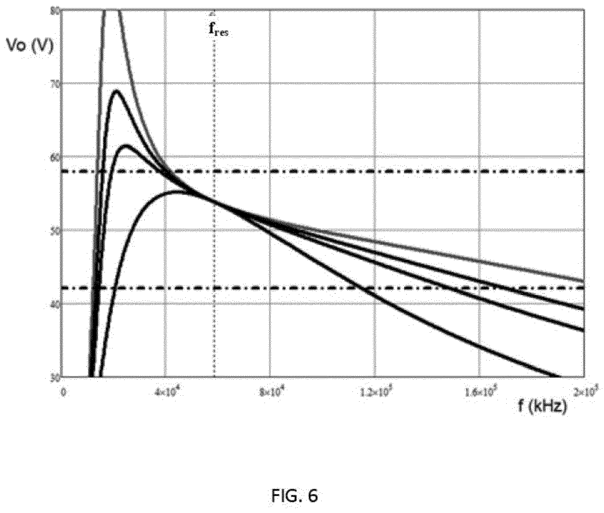

Figure 6 illustrate exemplary voltage gain characteristics for different quality factors of a three-phase resonant DC-DC converter system 300 incorporating aspects of the disclosed embodiments. The DC output voltage Vo is presented along the Y-axis while the frequency f (kHz) is presented along the X-axis. As can be seen from the graphs, the natural resonance frequency fᵣₑₛ is similar to the LLC type resonant converter.

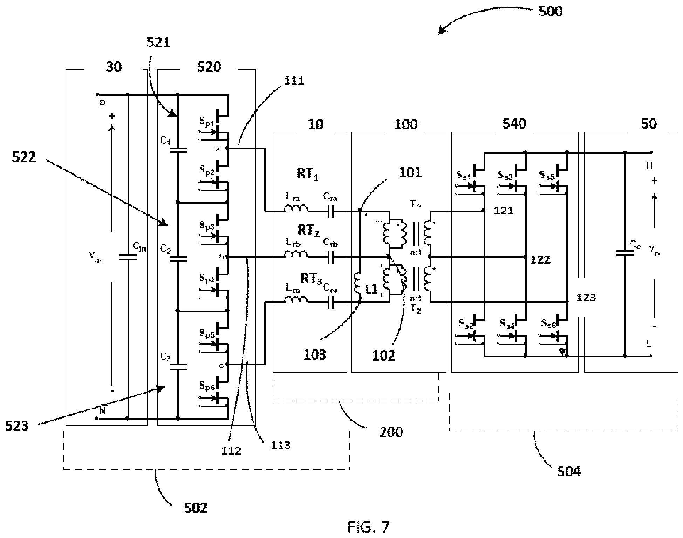

The two-transformer, three-phase resonant DC-DC converter 300 of the disclosed embodiments is suitable for any application that requires galvanic isolation and independence of the voltage value in the output of the system. Figure 7 illustrates one embodiment of a two-transformer, three-phase resonant converter system for a high voltage application. In this example, the resonant converter system 500 is a multi-level converter. The primary side 502 of the resonant converter system 500 includes a multi-level inverter circuit 520.

In this example, the inverter circuit 520 includes pairs of switches Sₚ₁, Sₚ₂, Sₚ₃, Sₚ₄, Sₚ₅, Sₚ₆ are connected in series with each other and a capacitor bank of series connected capacitors C₁, C₂ and C₃ is connected between the positive rail P and the negative rail N. A first terminal of capacitor C₁ is connected to the positive rail P and a first terminal of switch Sₚ₁. A second terminal of capacitor C₁ is connected to a first terminal of capacitor C₂, a second terminal of switch Sₚ₂ and a first terminal of switch Sₚ₃. The second terminal of switch Sₚ₁ is connected to the first terminal of switch Sₚ₃ and the connection forms output node 111. The output node 111 is connected to the first branch RT₁ of the resonant tank 10.

The second terminal of capacitor C₂ is connected to the second terminal of switch Sₚ₄, the first terminal of capacitor C₃ and the first terminal of switch Sₚ₅. The second terminal of switch Sₚ₃ is connected to the first terminal of switch Sₚ₄ and forms output node 112. Node 112 is connected to the second branch RT₂ of the resonant tank 10.

The second terminal of capacitor C₃ is connected to the negative rail N and the second terminal of switch Sₚ₆. The second terminal of switch Sₚ₅ is connected to the first terminal of switch Sₚ₆ and the connection form output node 113. Node 113 is connected to the third branch RT₃ of the resonant tank 10.

Each switch Sₚ₁, Sₚ₂, Sₚ₃, Sₚ₄, Sₚ₅, Sₚ₆ is configured to be operated, i.e. turned on or off, by a switch control signal to produce the three-phase power suitable to drive the resonant converter circuit 200. In one embodiment, the switching pattern of the control signals is phase shifted 120 degrees among each half-bridge leg 521, 522, 523 of the inverter circuit. In this example, the switches Sₚ₁, Sₚ₂, Sₚ₃, Sₚ₄, Sₚ₅, Sₚ₆ in the inverter circuit 520 on the primary side 502 and the switches Sₛ₁, Sₛ₂, Sₛ₃, Sₛ₄, Sₛ₅, Sₛ₆ in the rectifier circuit 540 on the secondary side 504 are wide band GaN-HEMT transistors. In alternate embodiments, the resonant converter system 500 can include any suitable switch types other than including wide band GaN-HEMT transistors.

The aspects of the disclosed embodiments are directed to a two-transformer, three-phase resonant DC-DC converter. The two-transformer circuit of the disclosed embodiments reduces the number of transformer windings, which results in a reduction in volume, weight and cost. The reliability of the resonant converter is increased, due to less losses in the transformer, which also eases the management of heat in the transformer. The number of capacitors needed for the input and output filters of the resonant converter is reduced, which also results in a reduction in volume, weight and cost. The inductors of the resonant tank can be integrated with each other into one single core. This topology results in a simplified and more efficient layout of the resonant converter components.

The voltage gain characteristic of the resonant converter of the disclosed embodiments is greater than one. This enables boost and buck modes of operation. Additionally, storage elements are not needed in order to achieve zero voltage switching on the primary side of the resonant converter and zero current switching on the secondary side of the resonant converter.

The resonant converter of the disclosed embodiments is suitable for any application that requires galvanic isolation and independence of the voltage value in the output of the system. Exemplary implementations include energy flow management for telecom power supplies. The two-transformer circuit of the disclosed embodiments can be applied to any three-phase topological circuit, including resonant and pulse wave modulated circuits. The circuits can be implemented for any power level as there is no inherent limitation in the topological circuits itself. The circuits can be extended for any number of converters and different kinds of connections (serial/parallel). A primary characteristic of the two-transformer, three-phase resonant converter circuit of the disclosed embodiments is that it can operate as a LLC type resonant converter.

It should be recognized that structures and/or elements shown and/or described in connection with any disclosed form or embodiment of the invention may be incorporated in any other disclosed or described or suggested form or embodiment as a general matter of design choice. It is the intention, therefore, to be limited only as indicated by the scope of the claims appended hereto.

## Claims

1. A resonant converter circuit (200) comprising:
a resonant tank circuit (10); and
a transformer circuit (100), wherein the resonant tank circuit (10) is connected to a primary side of three connection points of the transformer circuit (100) configured to receive a three-phase power input from the resonant tank circuit (10),
the transformer circuit (100) comprising:
a first transformer (T1) and a second transformer (T2), a first terminal (T1-1) of the first transformer (T1) connected to a first terminal (T2-1) of the second transformer (T2); and an inductor (L1) connected between a second terminal (T1-2) of the first transformer (T1) and a second terminal (T2-2) of the second transformer (T2), wherein the transformer circuit is a two-winding high frequency transformer circuit;
the primary side of the transformer circuit (100) comprising a first input node (101) formed by a connection of the second terminal (T1-2) of the first transformer (T1) and a first terminal (L1-1) of the inductor (L1), a second input node (102) formed by the connection of the first terminal (Tl-1) of the first transformer (T1) and the first terminal (T2-1) of the second transformer (T2) and a third input node (103) formed by a connection of the second terminal (T2-2) of the second transformer (T2) and a second terminal (LI-2) of the inductor (L1);
the resonant tank circuit (10) comprising a first branch (RT₁) comprising an inductor (Lᵣₐ) in series with a capacitor (Cᵣₐ), a second branch (RT₂) comprising an inductor (L_{rb}) in series with a capacitor (C_{rb}), and a third branch (RT₃) comprising an inductor (L_{rc}) in series with a capacitor (C_{rc}), wherein the first branch (RT₁) is connected to the first input node (101) of the transformer circuit (100), the second branch (RT₂) is connected to the second input node (102) of the transformer circuit (100), and the third branch (RT₃) is connected to the third input node (103) of the transformer circuit (100);
wherein the first input node (101) is configured to receive a first phase of the three-phase power input, the second node (102) is configured to receive a second phase of the three-phase power input and the third node (103) is configured to receive a third phase of the three-phase power input; and the transformer circuit (100) comprising a secondary side configured to deliver a three-phase power output, the secondary side comprising a first output node (121) formed by a third terminal (T1-3) of the first transformer (T1), a second output node (122) formed by a connection of a fourth terminal (T1-4) of the first transformer (T1) and a fourth terminal (T2-4) of the second transformer (T2), and a third output node (123) formed by a third terminal (T2-3) of the second transformer (T2).

2. The resonant converter circuit (200) according to claim 1, wherein the first branch (RT₁) is connected between the first input node (111) of the resonant tank circuit (10) and the first input node (101) of the transformer circuit (100), the second branch (RT₁) is connected between a second input node (112) of the resonant tank circuit (10) and the input node (102) of the transformer circuit (100), and the third branch (RT₃) is connected between a third input node (113) of the resonant tank circuit (10) and the third input node (103) of the transformer circuit (100).

3. The resonant converter circuit (200) according to claim 1 or 2 wherein the first branch (RT₁) comprises a first branch inductor (Lᵣₐ) connected in series with a first branch capacitor (Cᵣₐ), a first end (RTi-1) of the first branch (RT₁) is connected to the first node (101) of the transformer circuit (100); the second branch (RT₂) comprises a second branch inductor (L_{rb}) connected in series with a second branch capacitor (C_{rb}), a first end (RT₂-1) of the second branch (RT₂) is connected to the second node (102) of the transformer circuit (100); and the third branch (RT₃) comprises a third branch inductor (L_{rc}) connected in series with a third branch capacitor (C_{rc}), a first end (RT₃-1) of the third branch (RT₃) is connected to the third node (103) of the transformer circuit (100).

4. The resonant converter circuit (200) according to any of the preceding claims, wherein the secondary side is configured to be connected to a three-phase rectifier circuit (40) to deliver the three-phase power output, the first output node (121) being configured to be connected to a first branch (41) of the rectifier circuit (40), the second output node (122) being configured to be connected to a second branch (42) of the rectifier circuit (40) and the third output node (123) being configured to be connected to a third branch (43) of the rectifier circuit (40).

5. A three-phase resonant DC-DC converter system (300) comprising:
a primary side (302);
a secondary side (304); and
a resonant converter circuit (200) according to any one of the preceding claims connected between the primary side (302) and the secondary side (304).

6. The three-phase resonant DC-DC converter system (300) according to claim 5, wherein the primary side (302) comprises a DC voltage input circuit (30) configured to receive a DC input voltage, the resonant tank circuit (10) being connected to the transformer circuit (100) to provide the three-phase power input to the transformer circuit (100) and a switching circuit (20) connected between the DC voltage input circuit (30) and the resonant tank circuit (10).

7. The three-phase DC-DC converter system (300) according to claim 5 or 6, wherein the secondary side (304) comprises a three-phase rectification circuit (40) connected between the transformer circuit (100) and a DC voltage output circuit (50), the rectification circuit (40) configured to receive the three-phase power output signal from the transformer circuit (100).

8. The three-phase DC-DC converter system (300) according to any one of claims 5-7, wherein switches (Sₚ₁, Sₚ₂, Sₚ₃, Sₚ₄, Sₚ₅, Sₚ₆) in the switching circuit (20) and switches (Sₛ₁, Sₛ₂, Sₛ₃, Sₛ₄, Sₛ₅, Sₛ₆) in the rectification circuit (40) comprise gallium-nitride (GaN) transistors.

## Patentansprüche

1. Resonanzwandlerschaltung (200), welche Folgendes umfasst:
eine Resonanztankschaltung (10); und
eine Transformatorschaltung (100), wobei die Resonanztankschaltung (10) mit einer Primärseite von drei Verbindungspunkten der Transformatorschaltung (100) verbunden ist, welche konfiguriert ist, um eine dreiphasige Leistungseingabe von der Resonanztankschaltung (10) zu empfangen,
wobei die Transformatorschaltung (100) umfasst:
einen ersten Transformator (T1) und einen zweiten Transformator (T2), wobei ein erster Anschluss (T1-1) des ersten Transformators (T1) mit einem ersten Anschluss (T2-1) des zweiten Transformators (T2) verbunden ist; und einen Induktor (L1), welcher zwischen einen zweiten Anschluss (T1-2) des ersten Transformators (T1) und einen zweiten Anschluss (T2-2) des zweiten Transformators (T2) geschaltet ist, wobei die Transformatorschaltung eine Hochfrequenztransformatorschaltung mit zwei Wicklungen ist;
wobei die Primärseite der Transformatorschaltung (100) einen ersten Eingabeknoten (101), welcher aus einer Verbindung des zweiten Anschlusses (T1-2) des ersten Transformators (T1) mit einem ersten Anschluss (L1-1) des Induktors (L1) besteht, einen zweiten Eingabeknoten (102), welcher aus der Verbindung des ersten Anschlusses (T1-1) des ersten Transformators (T1) mit dem ersten Anschluss (T2-1) des zweiten Transformators (T2) besteht, und einen dritten Eingabeknoten (103), welcher aus einer Verbindung des zweiten Anschlusses (T2-2) des zweiten Transformators (T2) mit einem zweiten Anschluss (L1-2) des Induktors (L1) besteht, umfasst;
wobei die Resonanztankschaltung (10) einen ersten Zweig (RT₁), welcher einen Induktor (Lᵣₐ) in Reihe mit einem Kondensator (Cᵣₐ) umfasst, einen zweiten Zweig (RT₂), welcher einen Induktor (L_{rb}) in Reihe mit einem Kondensator (C_{rb}) umfasst, und einen dritten Zweig (RT₃), welcher einen Induktor (L_{rc}) in Reihe mit einem Kondensator (C_{rc}) umfasst, umfasst,
wobei der erste Zweig (RT₁) mit dem ersten Eingabeknoten (101) der Transformatorschaltung (100) verbunden ist, wobei der zweite Zweig (RT₂) mit dem zweiten Eingabeknoten (102) der Transformatorschaltung (100) verbunden ist, und der dritte Zweig (RT₃) mit dem dritten Eingabeknoten (103) der Transformatorschaltung (100) verbunden ist;
wobei der erste Eingabeknoten (101) konfiguriert ist, um eine erste Phase der dreiphasigen Leistungseingabe zu empfangen, der zweite Knoten (102) konfiguriert ist, um eine zweite Phase der dreiphasigen Leistungseingabe zu empfangen und der dritte Knoten (103) konfiguriert ist, um eine dritte Phase der dreiphasigen Leistungseingabe zu empfangen; und wobei die Transformatorschaltung (100) eine Sekundärseite umfasst, welche konfiguriert ist, um eine dreiphasige Leistungsausgabe bereitzustellen, wobei die Sekundärseite einen ersten Ausgabeknoten (121), welcher aus einem dritten Anschluss (T1-3) des ersten Transformators (T1) besteht, einen zweiten Ausgabeknoten (122), welcher aus einer Verbindung eines vierten Anschlusses (T1-4) des ersten Transformators (T1) mit einem vierten Anschluss (T2-4) des zweiten Transformators (T2) besteht, und einen dritten Ausgabeknoten (123), welcher aus einem dritten Anschluss (T2-3) des zweiten Transformators (T2) besteht, umfasst.

2. Resonanzwandlerschaltung (200) nach Anspruch 1, wobei der erste Zweig (RT₁) zwischen den ersten Eingabeknoten (111) der Resonanztankschaltung (10) und den ersten Eingabeknoten (101) der Transformatorschaltung (100) geschaltet ist, wobei der zweite Zweig (RT₂) zwischen einen zweiten Eingabeknoten (112) der Resonanztankschaltung (10) und den Eingabeknoten (102) der Transformatorschaltung (100) geschaltet ist und wobei der dritte Zweig (RT₃) zwischen einen dritten Eingabeknoten (113) der Resonanztankschaltung (10) und den dritten Eingabeknoten (103) der Transformatorschaltung (100) geschaltet ist.

3. Resonanzwandlerschaltung (200) nach Anspruch 1 oder 2, wobei der erste Zweig (RT₁) einen ersten Zweiginduktor (Lᵣₐ) umfasst, welcher in Reihe mit einem ersten Zweigkondensator (Cᵣₐ) verbunden ist, wobei ein erstes Ende (RT₁-1) des ersten Zweiges (RT₁) mit dem ersten Knoten (101) der Transformatorschaltung (100) verbunden ist; wobei der zweite Zweig (RT₂) einen zweiten Zweiginduktor (L_{rb}) umfasst, welcher in Reihe mit einem zweiten Zweigkondensator (C_{rb}) verbunden ist, wobei ein erstes Ende (RT₂-1) des zweiten Zweiges (RT₂) mit dem zweiten Knoten (102) der Transformatorschaltung (100) verbunden ist; und wobei der dritte Zweig (RT₃) einen dritten Zweiginduktor (L_{rc}) umfasst, welcher in Reihe mit einem dritten Zweigkondensator (C_{rc}) verbunden ist, wobei ein erstes Ende (RT₃-1) des dritten Zweiges (RT₃) mit dem dritten Knoten (103) der Transformatorschaltung (100) verbunden ist.

4. Resonanzwandlerschaltung (200) nach einem der vorhergehenden Ansprüche, wobei die Sekundärseite konfiguriert ist, um mit einer dreiphasigen Gleichrichterschaltung (40) verbunden zu werden, um die dreiphasige Leistungsausgabe bereitzustellen, wobei der erste Ausgabeknoten (121) konfiguriert ist, um mit einem dritten Zweig (41) der Gleichrichterschaltung (40) verbunden zu werden, wobei der zweite Ausgabeknoten (122) konfiguriert ist, um mit einem zweiten Zweig (42) der Gleichrichterschaltung (40) verbunden zu werden, und der dritte Ausgabeknoten (123) konfiguriert ist, um mit einem dritten Zweig (43) der Gleichrichterschaltung (40) verbunden zu werden.

5. Dreiphasiges Gleichstromresonanzwandlersystem (300), umfassend:
eine Primärseite (302);
eine Sekundärseite (304); und
eine Resonanzwandlerschaltung (200) nach einem der vorhergehenden Ansprüche, welche zwischen die Primärseite (302) und die Sekundärseite (304) geschaltet ist.

6. Dreiphasiges Gleichstromresonanzwandlersystem (300) nach Anspruch 5, wobei die Primärseite (302) eine Gleichspannungseingabeschaltung (30) umfasst, welche konfiguriert ist, um eine Eingabegleichspannung zu empfangen, wobei die Resonanztankschaltung (10) mit der Transformatorschaltung (100) verbunden ist, um die dreiphasige Leistungseingabe an der Transformatorschaltung (100) bereitzustellen, sowie eine Umschaltschaltung (20), welche zwischen die Gleichspannungseingabeschaltung (30) und die Resonanztankschaltung (10) geschaltet ist.

7. Dreiphasiges Gleichstromresonanzwandlersystem (300) nach Anspruch 5 oder 6, wobei die Sekundärseite (304) eine dreiphasige Gleichrichterschaltung (40) umfasst, welche zwischen die Transformatorschaltung (100) und eine Gleichspannungsausgabeschaltung (50) geschaltet ist, wobei die Gleichrichterschaltung (40) konfiguriert ist, um das dreiphasige Leistungsausgabesignal von der Transformatorschaltung (100) zu empfangen.

8. Dreiphasiges Gleichstromresonanzwandlersystem (300) nach einem der Ansprüche 5-7, wobei Schalter (Sₚ₁, Sₚ₂, Sₚ₃, Sₚ₄, Sₚ₅, Sₚ₆) in der Umschaltschaltung (20) und Schalter (Sₛ₁, Sₛ₂, Sₛ₃, Sₛ₄, Sₛ₅, Sₛ₆) in der Gleichrichterschaltung (40) Gallium-Nitrid-(GaN)-Transistoren umfassen.

## Revendications

1. Circuit convertisseur résonant (200) comprenant :
un circuit résonant parallèle (10) ; et
un circuit transformateur (100), le circuit résonant parallèle (10) étant connecté à un côté primaire des trois points de connexion du circuit transformateur (100) conçu pour recevoir une entrée de puissance triphasée provenant du circuit résonant parallèle (10),
le circuit transformateur (100) comprenant :
un premier transformateur (T1) et un second transformateur (T2), une première borne (T1-1) du premier transformateur (T1) étant connectée à une première borne (T2-1) du second transformateur (T2) ; et un inducteur (L1), connecté entre une deuxième borne (T1-2) du premier transformateur (T1) et une deuxième borne (T2-2) du second transformateur (T2), le circuit transformateur étant un circuit transformateur haute fréquence à deux enroulements ;
le côté primaire du circuit transformateur (100) comprenant un premier nœud d'entrée (101), formé par une connexion de la deuxième borne (T1-2) du premier transformateur (T1) et d'une première borne (L1-1) de l'inducteur (L1), un deuxième nœud d'entrée (102), formé par la connexion de la première borne (T1) du premier transformateur (T1) et de la première borne (T2-1) du second transformateur (T2), et un troisième nœud d'entrée (103), formé par une connexion de la deuxième borne (T2-2) du second transformateur (T2) et d'une deuxième borne (L1-2) de l'inducteur (L1) ;
le circuit résonant parallèle (10) comprenant une première branche (RT₁) comprenant un inducteur (Lᵣₐ), en série avec un condensateur (Cᵣₐ), une deuxième branche (RT₂) comprenant un inducteur (L_{rb}), en série avec un condensateur (C_{rb}), et une troisième branche (RT₃) comprenant un inducteur (L), en série avec un condensateur (C_{rc}),
la première branche (RT₁) étant connectée au premier nœud d'entrée (101) du circuit transformateur (100), la deuxième branche (RT₂) étant connectée au deuxième nœud d'entrée (102) du circuit transformateur (100) et la troisième branche (RT₃) étant connectée au troisième nœud d'entrée (103) du circuit transformateur (100) ;
le premier nœud d'entrée (101) étant conçu pour recevoir une première phase de l'entrée de puissance triphasée, le deuxième nœud (102) étant conçu pour recevoir une deuxième phase de l'entrée de puissance triphasée et le troisième nœud (103) est conçu pour recevoir une troisième phase de l'entrée de puissance triphasée ; et le circuit transformateur (100) comprenant un côté secondaire, conçu pour produire une sortie de puissance triphasée, le côté secondaire comprenant un premier nœud de sortie (121), formé par une troisième borne (T1-3) du premier transformateur (T1), un deuxième nœud de sortie (122), formé par une connexion d'une quatrième borne (T1-4) du premier transformateur (T1) et une quatrième borne (T2-4) du second transformateur (T2), et un troisième nœud de sortie (123), formé par une troisième borne (T2-3) du second transformateur (T2).

2. Circuit convertisseur résonant (200) selon la revendication 1, dans lequel la première branche (RT₁) est connectée entre le premier nœud d'entrée (111) du circuit résonant parallèle (10) et le premier nœud d'entrée (101) du circuit transformateur (100), où la deuxième branche (RT₁) est connectée entre un deuxième nœud d'entrée (112) du circuit résonant parallèle (10) et où le nœud d'entrée (102) du circuit transformateur (100) et la troisième branche (RT₃) est connectée entre un troisième nœud d'entrée (113) du circuit résonant parallèle (10) et le troisième nœud d'entrée (103) du circuit transformateur (100).

3. Circuit convertisseur résonant (200) selon la revendication 1 ou 2, dans lequel la première branche (RT₁) comprend un premier inducteur de branche (Lᵣₐ) branché en série avec un premier condensateur de branche (Cᵣₐ), où une première extrémité (RT₁-1), de la première branche (RT₃) est connectée au premier nœud (101) du circuit transformateur (100) ; dans lequel la deuxième branche (RT₂) comprend un deuxième inducteur de branche (L_{rb}) branché en série avec un deuxième condensateur de branche (C_{rb}), où une première extrémité (RT₂-1) de la deuxième branche (RT₂) est connectée au deuxième nœud (102) du circuit transformateur (100) ; et dans lequel la troisième branche (RT₃) comprend un troisième inducteur de branche (L_{rc}) branché en série avec un troisième condensateur de branche (C_{rc}), où une première extrémité (RT₃-1) de la troisième branche (RT₃) est connectée au troisième nœud (103) du circuit transformateur (100).

4. Circuit convertisseur résonant (200) selon l'une quelconque des revendications précédentes, dans lequel le côté secondaire est conçu pour être connecté à un circuit redresseur triphasé (40) pour produire la sortie de puissance triphasée, le premier nœud de sortie (121) étant conçu pour être connecté à une première branche (41) du circuit redresseur (40), le deuxième nœud de sortie (122) étant conçu pour être connecté à une deuxième branche (42) du circuit redresseur (40) et le troisième nœud de sortie (123) étant conçu pour être connecté à une troisième branche (43) du circuit redresseur (40).

5. Système de convertisseur CC-CC résonant triphasé (300) comprenant :
un côté primaire (302) ;
un côté secondaire (304) ; et
un circuit convertisseur résonant (200) selon l'une quelconque des revendications précédentes, branché entre le côté primaire (302) et le côté secondaire (304).

6. Système de convertisseur CC-CC résonant triphasé (300) selon la revendication 5, dans lequel le côté primaire (302) comprend un circuit d'entrée en tension continue (30) conçu pour recevoir une tension d'entrée continue, le circuit résonant parallèle (10) étant connecté au circuit transformateur (100) pour fournir l'entrée de puissance triphasée au circuit transformateur (100) et un circuit de commutation (20) étant branché entre le circuit d'entrée de tension continue (30) et le circuit résonant parallèle (10).

7. Système de convertisseur CC-CC triphasé (300) selon la revendication 5 ou 6, dans lequel le côté secondaire (304) comprend un circuit de redressement triphasé (40) branché entre le circuit transformateur (100) et un circuit de sortie en tension continue (50), le circuit de redressement (40) étant conçu pour recevoir le signal de sortie de puissance triphasée provenant du circuit transformateur (100).

8. Système de convertisseur CC-CC triphasé (300) selon l'une quelconque des revendications 5 à 7, dans lequel les commutateurs (Sₚ₁, Sₚ₂, Sₚ₃, Sₚ₄, Sₚ₅, Sₚ₆) du circuit de commutation (20) et les commutateurs (Sₛ₁, Sₛ₂, Sₛ₃, Sₛ₄, Sₛ₅, Sₛ₆) du circuit de redressement (40) comprennent de transistors au nitrure de gallium (GaN).
